# EUROPEAN PATENT SPECIFICATION

(11) **EP 1 548 904 B1**
(45) Date of publication and mention of the grant of the patent: **18.10.2006**
(21) Application number: 04018719.7
(22) Date of filing: 06.08.2004
(51) Int. Cl.: H01S 3/063

(54) **Silicon nitride thin film for optical device and fabrication method thereof**
Dünnschicht aus Siliziumnitrid für optisches Bauelement und Herstellungsverfahren derselben
Couche mince de nitrure de silicium pour composant optique et méthode de fabrication associée

(30) Priority: 26.12.2003 KR 2003097049
(43) Date of publication of application: 29.06.2005
(73) Proprietor: ELECTRONICS AND TELECOMMUNICATIONS RESEARCH INSTITUTE, Daejon-Shi (KR)
(72) Inventor: Park, Nae Man, Daejon-Shi (KR); Kim, Tae Youb, Seoul (KR); Sung, Gun Yong, Hanbit Apt. 135-1301, Daejeon-Shi (KR)
(74) Representative: Betten & Resch

(56) References cited:
- US-A1- 2002 066 720
- US-A1- 2002 153 522

## Description

### BACKGROUND

### 1. Field of the Invention

The present invention relates to a silicon nitride thin film and method for fabricating the same, and more particularly, to a silicon nitride thin film and method for fabricating the same, which comprises rare earth elements and amorphous silicon quantum dots in the silicon nitride thin film to enhance excitation efficiency of the rare earth element, so that it may be effectively applied to an optical device.

### 2. Discussion of Related Art

In general, silica based thin films doped with rare earth elements are widely used to fabricate a waveguide optical amplifier. However, an excitation cross sectional area of the rare earth element is very small to a degree of about 1x10⁻²¹ cm⁻², so that the optical efficiency is significantly low in this case. When a thin film containing nano-dots instead of the silica based thin film is doped with the rare earth elements, excitation efficiency of the rare earth elements becomes higher, because the recombination efficiency of electrons and holes within the nano-dots is very high to thereby effectively excite rare earth elements. For this reason, development and researches for the silicon oxide thin film in which crystalline silicon nano-dots are comprised are conducted in recent years.

US Patent Application US 2002/0153522 discloses a silicon nitride thin film for an optical device comprising amorphous silicon quantum dots.

However, the optical efficiency is not sufficient for application of a light-emitting device so as to have high efficiency, and an oxide based thin film is used, so that an operating voltage of the device is still high.

### SUMMARY OF THE INVENTION

The present invention is directed to a silicon nitride thin film wherein rare earth elements are excited by amorphous silicon quantum dots, which are superior to crystalline silicon nano-dots in terms of luminous efficiency to thereby enhance luminous efficiency of rare earth elements.

The present invention is also directed to a method for fabricating silicon nitride thin film having a relatively small energy gap instead of silicon oxide to enhance operation characteristics of a device when the device is fabricated.

One aspect of the present invention is to provide a silicon nitride thin film for an optical device, wherein amorphous silicon quantum dots and rare earth elements are comprised in the silicon nitride thin film, and rare earth elements are excited by the amorphous silicon quantum dots to emit light.

Another aspect of the present invention is to provide a method for fabricating a silicon nitride thin film for an optical device, which comprises steps of growing silicon nitride in which amorphous silicon quantum dots are comprised, and doping rare earth elements within the silicon nitride thin film, wherein rare earth elements are excited by the amorphous silicon quantum dots to emit light.

Still another aspect of the present invention is to provide a method for fabricating a silicon nitride thin film for an optical device, which comprises doping rare earth elements within the silicon nitride thin film while growing silicon nitride in which amorphous silicon quantum dots are comprised, wherein rare earth elements are excited by the amorphous silicon quantum dots to emit light.

### BRIEF DESCRIPTION OF THE DRAWINGS

FIG. 1 is a conceptual view of a silicon nitride thin film for an optical device in accordance with an embodiment of the present invention.

FIG. 2 is a flow chart for explaining a method for fabricating a silicon nitride thin film for an optical device in accordance with an embodiment of the present invention.

FIG. 3 is a graph for showing luminous efficiencies of crystalline silicon nano-dots and amorphous silicon quantum dots.

FIG. 4 is a graph for showing luminous characteristic of erbium doped within a silicon nitride thin film for an optical device, and luminous characteristic of erbium doped within crystalline silicon in accordance with an embodiment of the present invention.

FIG. 5 is a graph for showing decay and rise phenomena of photoluminescence measured to compute an excitation cross sectional area of erbium in the silicon nitride thin film for the optical device of FIG. 4 in terms of time.

### DETAILED DESCRIPTION OF PREFERRED EMBODIMENTS

The present invention will now be described more fully hereinafter with reference to the accompanying drawings. This invention may, however, be embodied in different forms and should not be construed as limited to the embodiments set forth herein. Rather, these embodiments are provided so that this disclosure will be thorough and complete, and will fully convey the scope of the invention to those skilled in the art. In the drawings, the thickness of layers and regions are exaggerated for clarity. Like numbers refer to like elements throughout the specification.

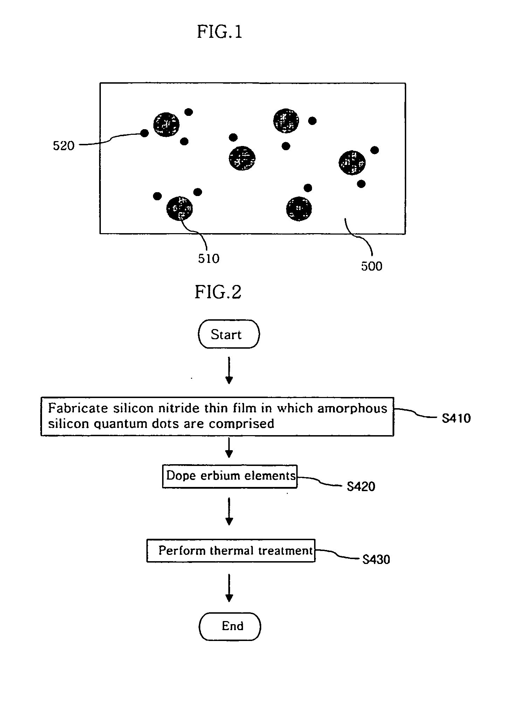

FIG. 1 is a conceptual view of a silicon nitride thin film for an optical device in accordance with an embodiment of the present invention. The silicon nitride thin film for the optical device 500 comprises amorphous silicon quantum dots 510 and rare earth elements 520, which are included, and the rare earth elements 520 are excited by the amorphous silicon quantum dots 510 to emit light.

One of main features of the present invention is that the silicon nitride thin film having a relatively small energy gap is employed and the amorphous silicon quantum dots 510 and the rare earth elements 520 are included together in the thin film, so that recombination efficiency of electrons and holes within the quantum dots is very high to effectively excite the rare earth elements. In other words, excitation of the rare earth elements 520 may permit luminous efficiency to be enhanced by means of electron energy delivered from the amorphous silicon quantum dots 510.

The rare earth elements 520 include erbium, europium, gadolinium, terbium, ytterbium, and so forth.

The size of the amorphous silicon quantum dot 510 is preferably 1 to 5nanometer.

Next, a method for fabricating the silicon nitride thin film for optical device will be described in detail with reference to FIG. 2 in accordance with an embodiment of the present invention. FIG. 2 is a flow chart for explaining a method for fabricating a silicon nitride thin film for an optical device in accordance with an embodiment of the present invention.

First, a step of forming the silicon nitride thin film in which amorphous silicon quantum dots are included is performed (S410). For example, nitride gas having a degree of purity of 99.9999% and 5% silane gas diluted in nitrogen gas may be employed to grow the amorphous silicon quantum dots on a silicon substrate by a plasma enhanced chemical vapor deposition (PECVD) method. The size of the quantum dots fabricated by the above-mentioned method is about 5nm or less.

In this case, the flow of the silane gas is 8 to 10sccm, growth pressure is 0.5Torr, and plasma power is constantly kept at 6 to 8W. Raw materials are deposited under conditions of 300 °C in growth temperature, 500 to 800sccm in flow of the nitride gas, and 2.4 to 3.2nm/min in growth speed.

Next, erbium is doped within the silicon nitride thin film by ion implanting method (S420). In this case, the amount of erbium is adjusted to be in a range of 1x10¹⁹ to 1x10²¹ cm⁻³, and ion-implanting energy is adjusted to be 40 to 130KeV so as to have erbium elements doped only within the thin film, and a number of implanting steps are performed to uniformly dope erbium elements within the thin film.

Next, the thermal treatment on the silicon nitride thin film into which erbium is implanted may be performed (S430). A temperature and a time of the thermal treatment may be adjusted to be in a range of 600 °C to 1000°C, and 10 to 60min, respectively. In the meantime, according to the experimental results, best luminous efficiency of the erbium element is obtained from raw materials that have been thermally treated to meet conditions of 900°C in temperature and 30min in thermal treatment time. Preferably, a nitride atmosphere is kept when the thermal treatment is performed, and a vacuum condition of a chamber is adjusted to be 10⁻⁴ Torr to the most before the thermal treatment is performed so as to suppress oxygen inflow during the thermal treatment.

In accordance with another embodiment of the present invention, rare earth elements may be doped within the silicon nitride thin film while silicon nitride in which amorphous silicon quantum dots are included is deposited by means of CVD equipment to thereby form the silicon nitride thin film for an optical device. In this case, the silicon nitride thin film for the optical device may be formed injecting metal organic raw materials into the CVD equipment. A temperature to be used is in a range of room temperature to about 500°C, gas to be used includes gas for depositing silicon, nitride gas, or ammonia gas. Examples of available erbium metal organic raw materials include ERBIUM III -HEPTAFLUORO-DIMETHYL-OCTANEDIONATE (C₃₀H₃₀ErF₂₁O₆), ERBIUM METHOXYETHOXIDE (C₉H₂₁ErO₆), ERBIUM 2-PENTANEDIONATE (C₁₅H₂₁ErO₆), ERBIUM -TETRAMETHYL-HEPTANEDIONATE (C₃₃H₅₇ErO₆), ERBIUM TRIS[BIS(TRIMETHYLSILYL)AMIDE] (C₁₈H₅₄ErN₃Si₆), and so forth.

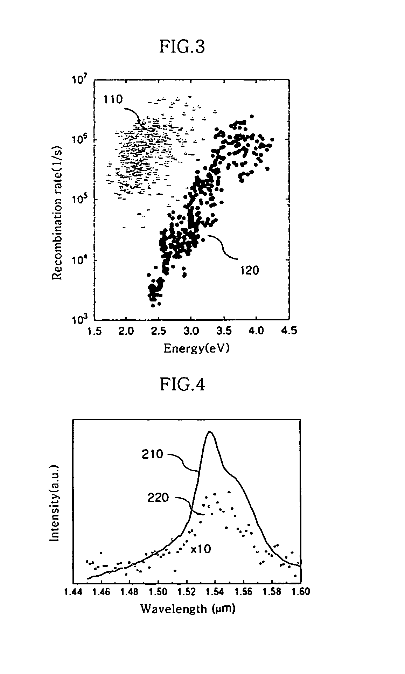

FIG. 3 is a graph for showing luminous efficiencies of crystalline silicon nano-dots and amorphous silicon quantum dots. Numerical reference 110 indicates a recombination rate of an electron and a hole of the amorphous silicon quantum dot, and numerical reference 120 indicates a recombination rate of the crystalline silicon nano-dots. It can be seen that the recombination rate of the amorphous silicon quantum dots is about 100 to 1000 times as high as that of the crystalline silicon nano-dots. In other words, the amorphous silicon quantum dots have luminous efficiency superior to that of the crystalline silicon nano-dots.

Hereinafter, the silicon nitride thin film for the optical device according to the embodiment of the present invention and the crystalline thin film containing doped erbium according to the related art will be compared.

FIG. 4 is a graph for showing luminous characteristic 210 of erbium doped within a silicon nitride thin film for an optical device, and luminous characteristic 220 of erbium doped within crystalline silicon in accordance with an embodiment of the present invention. The amorphous silicon quantum dots are grown within the silicon nitride and erbium among the rare earth elements is doped thereto so that the silicon nitride thin film for the optical device is fabricated in accordance with the embodiment of the present invention. Referring to FIG. 4, it can be seen that the luminous efficiency of the silicon nitride thin film for the optical device is 10 times superior to that of the erbium doped within the crystalline silicon. This result occurs from the fact that the amorphous silicon quantum dot effectively excites the erbium so that energy delivery from the amorphous silicon quantum dots to the erbium elements is effectively made.

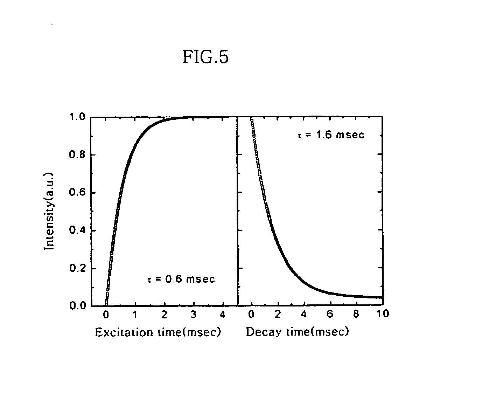

FIG. 5 is a graph for showing decay and rise phenomena of photoluminescence measured to compute excitation cross sectional area of erbium in the silicon nitride thin film for optical device of FIG. 4 in terms of time. Referring to FIG. 5, the rising time of the photoluminescence of erbium is about 0.6msec, and the decay time is about 1.6msec. From these values and the following equation 1/T ₒₙ - 1/T _{decay} = σ φ wherein **T** ₒₙ is a rising time, T decay is a decay time, σ is an excitation cross sectional area, and φ is a laser power for excitation, the excitation cross sectional area becomes about 1x10 ¹⁶cm⁻², which means that the area increases about 100,000 times a general excitation cross sectional area.

As mentioned above, amorphous silicon quantum dots are used as excitation medium to thereby significantly enhance the luminous efficiency of rare earth elements, and the silicon nitride thin film having a relatively small energy gap is employed instead of silicon oxide thin film to thereby provide a margin for improving operation characteristic of the device. Thus, this enables the optical device having a high efficiency to be fabricated, which may lead to bring an innovational change in a semiconductor industry.

While the present invention has been described with reference to a particular embodiment, it is understood that the disclosure has been made for purpose of illustrating the invention by way of examples and is not limited to limit the scope of the invention. And one skilled in the art can make amend and change the present invention without departing from the scope of the invention as defined by the appended claims.

## Claims

1. A silicon nitride thin film for an optical device, comprising:
amorphous silicon quantum dots (510) and rare earth elements (520) included together,
wherein the rare earth elements are excited by the amorphous silicon quantum dots to emit light.

2. The silicon nitride thin film as claimed in claim 1, wherein the rare earth elements (520) include any one of erbium, europium, gadolinium, terbium, and ytterbium.

3. The silicon nitride thin film as claimed in claim 1 or 2, wherein the amorphous silicon quantum dot (510) has a size of 1 to 5 nanometers.

4. A method for fabricating a silicon nitride thin film for an optical device, comprising the steps of:
growing silicon nitride in which amorphous silicon quantum dots are included; and
doping rare earth elements within the silicon nitride thin film,
wherein the rare earth elements are excited by the amorphous silicon quantum dots to emit light.

5. The method as claimed in claim 4, further comprising a step of:
performing thermal treatment at a temperature of 600°C to 1000°C for 30 minutes to 60 minutes after the rare earth elements are doped.

6. The method as claimed in claim 4 or 5, wherein the amorphous silicon quantum dot has a size of 1 to 5 nanometers.

7. The method as claimed in one of claims 4 to 6, wherein the silicon nitride in which the amorphous silicon quantum dots are included is grown by any one of a plasma enhanced chemical vapor deposition (PECVD) method and a sputtering method under conditions of 0.1 to 10Torr in deposition pressure, 0.2 to 1W/cm² in plasma power, and room temperature to 400°C in growth temperature.

8. The method as claimed in one of claims 4 to 7, wherein the rare earth elements are doped by means of an ion implantation method.

9. A method for fabricating a silicon nitride thin film for an optical device, comprising a step of:
doping rare earth elements within the silicon nitride thin film while growing silicon nitride in which amorphous silicon quantum dots are included,
wherein the rare earth elements are excited by the amorphous silicon quantum dots to emit light.

10. The method as claimed in claim 9, wherein the rare earth elements are doped within the silicon nitride thin film using metal organic raw materials.

11. The method as claimed in claim 9 or 10, further comprising a step of:
performing thermal treatment at a temperature of 600°C to 1000°C for 30 minutes to 60 minutes after the rare earth elements are doped.

12. The method as claimed in one of claims 9 to 11, wherein the amorphous silicon quantum dot has a size of 1 to 5 nanometers.

13. The method as claimed in one of claims 9 to 12, wherein the silicon nitride in which the amorphous silicon quantum dots are dispersed is grown by any one of a plasma enhanced chemical vapor deposition (PECVD) method and a sputtering method under conditions of 0.1 to 10Torr in deposition pressure, 0.2 to 1W/cm² in plasma power, and room temperature to 400°C in growth temperature.

## Patentansprüche

1. Siliziumnitrid-Dünnfilm für eine optische Vorrichtung, der Folgendes umfasst:
Quantenpunkte aus amorphem Silizium (510) und Seltene-Erden-Elemente (520), die zusammen enthalten sind,
wobei die Seltene-Erden-Elemente durch die Quantenpunkte aus amorphem Silizium angeregt werden, Licht zu emittieren.

2. Siliziumnitrid-Dünnfilm wie in Anspruch 1 beansprucht, bei dem die Seltene-Erden-Elemente (520) eines der Elemente Erbium, Europium, Gadolinium, Terbium und Ytterbium enthalten.

3. Siliziumnitrid-Dünnfilm wie in Anspruch 1 oder 2 beansprucht, bei dem der Quantenpunkt aus amorphem Silizium (510) eine Größe von 1 bis 5 Nanometer hat.

4. Verfahren zur Herstellung eines Siliziumnitrid-Dünnfilm für eine optische Vorrichtung, das die folgenden Schritte umfasst:
Aufwachsen von Siliziumnitrid, in dem Quantenpunkte aus amorphem Silizium enthalten sind, und
Dotieren von Seltene-Erden-Elementen in den Siliziumnitrid-Dünnfilm,
wobei die Seltene-Erden-Elemente durch die Quantenpunkte aus amorphem Silizium angeregt werden, Licht zu emittieren.

5. Verfahren wie in Anspruch 4 beansprucht, das weiterhin den folgenden Schritt umfasst:
Durchführen einer 30 Minuten bis 60 Minuten langen Wärmebehandlung bei einer Temperatur von 600 °C bis 1000 °C, nachdem die Seltene-Erden-Elemente dotiert sind.

6. Verfahren wie in Anspruch 4 oder 5 beansprucht, bei dem der Quantenpunkt aus amorphem Silizium eine Größe von 1 bis 5 Nanometer hat.

7. Verfahren wie in einem der Ansprüche 4 bis 6 beansprucht, bei dem das Siliziumnitrid, in dem die Quantenpunkte aus amorphem Silizium enthalten sind, aufgewachsen wird durch eines der Verfahren plasmaangereicherte chemische Dampfabscheidung (PECVD) und Sputtern unter Bedingungen von 0,1 bis 10 Torr Abscheidungsdruck, 0,2 bis 1 W/cm² Plasmaleistung und einer Aufwachstemperatur von Raumtemperatur bis 400 °C.

8. Verfahren wie in einem der Ansprüche 4 bis 7 beansprucht, bei dem die Seltene-Erden-Elemente mittels eines lonenimplantationsverfahrens dotiert werden.

9. Verfahren zur Herstellung eines Siliziumnitrid-Dünnfilm für eine optische Vorrichtung, das den folgenden Schritt umfasst:
Dotieren von Seltene-Erden-Elementen in den Siliziumnitrid-Dünnfilm während Aufwachsen von Siliziumnitrid, in dem Quantenpunkte aus amorphem Silizium enthalten sind,
wobei die Seltene-Erden-Elemente durch die Quantenpunkte aus amorphem Silizium angeregt werden, Licht zu emittieren.

10. Verfahren wie in Anspruch 9 beansprucht, bei dem die Seltene-Erden-Elemente unter Verwendung von metallorganischen Rohmaterialien in den Siliziumnitrid-Dünnfilm dotiert werden.

11. Verfahren wie in Anspruch 9 oder 10 beansprucht, das weiterhin den folgenden Schritt umfasst:
Durchführen einer 30 Minuten bis 60 Minuten langen Wärmebehandlung bei einer Temperatur von 600 °C bis 1000 °C, nachdem die Seltene-Erden-Elemente dotiert sind.

12. Verfahren wie in einem der Ansprüche 9 bis 11 beansprucht, bei dem der Quantenpunkt aus amorphem Silizium eine Größe von 1 bis 5 Nanometer hat.

13. Verfahren wie in einem der Ansprüche 9 bis 12 beansprucht, bei dem das Siliziumnitrid, in dem die Quantenpunkte aus amorphem Silizium verteilt sind, aufgewachsen wird durch eines der Verfahren plasmaangereicherte chemische Dampfabscheidung (PECVD) und Sputtern unter Bedingungen von 0,1 bis 10 Torr Abscheidungsdruck, 0,2 bis 1 W/cm² Plasmaleistung und einer Aufwachstemperatur von Raumtemperatur bis 400 °C.

## Revendications

1. Film mince de nitrure de silicium pour un dispositif optique, comprenant :
des points quantiques de silicium amorphe (510) et des lanthanides (520) inclus ensemble,
dans lequel les lanthanides sont excités par les points quantiques de silicium amorphe pour émettre de la lumière.

2. Film mince de nitrure de silicium selon la revendication 1, dans lequel les lanthanides (520) comprennent l'un quelconque parmi l'erbium, l'europium, le gadolinium, le terbium et l'ytterbium.

3. Film mince de nitrure de silicium selon la revendication 1 ou 2, dans lequel le point quantique de silicium amorphe (510) a une taille de 1 à 5 nanomètres.

4. Procédé de fabrication d'un film mince de nitrure de silicium pour un dispositif optique, comprenant les étapes consistant à :
faire croître du nitrure de silicium dans lequel des points quantiques de silicium amorphe sont inclus ; et
doper des lanthanides à l'intérieur du film mince de nitrure de silicium,
dans lequel les lanthanides sont excités par les points quantiques de silicium amorphe pour émettre de la lumière.

5. Procédé selon la revendication 4, comprenant en outre une étape consistant à :
effectuer un traitement thermique à une température de 600 °C à 1 000 °C pendant 30 minutes à 60 minutes après que les lanthanides aient été dopés.

6. Procédé selon la revendication 4 ou 5, dans lequel le point quantique de silicium amorphe a une taille de 1 à 5 nanomètres.

7. Procédé selon l'une quelconque des revendications 4 à 6, dans lequel le nitrure de silicium dans lequel les points quantiques de silicium amorphe sont inclus, est mis à croître par l'un quelconque parmi un procédé de dépôt chimique en phase vapeur activé par plasma (PECVD) et un procédé de pulvérisation cathodique dans des conditions de 0,1 à 10 Torr de pression de dépôt, de 0,2 à 1 W/cm² de puissance de plasma, et de la température ambiante à 400 °C en température de croissance.

8. Procédé selon l'une quelconque des revendications 4 à 7, dans lequel les lanthanides sont dopés au moyen d'un procédé d'implantation ionique.

9. Procédé de fabrication d'un film mince de nitrure de silicium pour un dispositif optique, comprenant une étape consistant à :
doper des lanthanides à l'intérieur du film mince de nitrure de silicium tout en faisant croître le nitrure de silicium dans lequel des points quantiques de silicium amorphe sont inclus,
dans lequel les lanthanides sont excités par les points quantiques de silicium amorphe pour émettre de la lumière.

10. Procédé selon la revendication 9, dans lequel les lanthanides sont dopés à l'intérieur du film mince de nitrure de silicium utilisant des matières premières organiques métalliques.

11. Procédé selon la revendication 9 ou 10, comprenant en outre une étape consistant à :
effectuer un traitement thermique à une température de 600 °C à 1 000 °C pendant 30 minutes à 60 minutes après que les lanthanides aient été dopés.

12. Procédé selon l'une quelconque des revendications 9 à 11, dans lequel le point quantique de silicium amorphe a une taille de 1 à 5 nanomètres.

13. Procédé selon l'une quelconque des revendications 9 à 12, dans lequel le nitrure de silicium dans lequel les points quantiques de silicium amorphe sont dispersés, est mis à croître par l'un quelconque parmi un procédé de dépôt chimique en phase vapeur activé par plasma (PECVD) et un procédé de pulvérisation cathodique dans des conditions de 0,1 à 10 Torr de pression de dépôt, de 0,2 à 1 W/cm² de puissance de plasma, et de la température ambiante à 400 °C en température de croissance.
